Europäisches Patentamt

European Patent Office

Office européen des brevets

(19)

(11) **EP 1 223 611 A1**

(12) **EUROPÄISCHE PATENTANMELDUNG**

(43) Veröffentlichungstag:
**17.07.2002 Patentblatt 2002/29**

(51) Int Cl.⁷: **H01L 21/58**, G01N 27/02

(21) Anmeldenummer: **01810635.1**

(22) Anmeldetag: **29.06.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(71) Anmelder: **Esec Trading S.A.**
**6330 Cham (CH)**

(72) Erfinder:
• **Mannhart, Eugen**
**6330 Cham (CH)**

• **Schmid, Reto**
**6300 Zug (CH)**
• **Fueglistaller, Quirin**
**8916 Jonen (CH)**

(74) Vertreter: **Falk, Urs, Dr.**
**Patentanwaltsbüro Dr. Urs Falk,**
**Eichholzweg 9A**
**6312 Steinhausen (CH)**

(54) **Einrichtung für das Auflöten von Halbleiterchips auf ein Substrat**

(57)     Eine Einrichtung für das Auflöten von Halbleiterchips (1) auf ein Substrat (2) weist eine Lotstation (5) zum Aufbringen einer Lotportion (6) auf das Substrat (2) und eine Bondstation (7) zum Plazieren eines Halbleiterchips (1) auf der Lotportion (6) auf. Für die Charakterisierung der Qualität der Lotportion (6) ist ein induktiver Sensor (8) vorhanden, der mindestens ein Signal (11.1; 11.2; 11.3) erzeugt, das von der Verteilung der Lotportion (6) auf dem Substrat (2) bzw. der Form der Lotportion (6) abhängig ist.

Fig. 1

EP 1 223 611 A1

**Beschreibung**

Die Erfindung betrifft eine Einrichtung für das Auflöten von Halbleiterchips auf ein Substrat mit einem Sensor zur Beurteilung der Qualität einer Lotportion.

Bei der Montage von Halbleiterchips ist es gebräuchlich, die Halbleiterchips, hauptsächlich Leistungshalbleiter mit dem Substrat, das üblicherweise aus Kupfer besteht, mittels Weichlötung zu verbinden, um über die Lötverbindung eine wirksame Ableitung der beim Betrieb entstehenden Verlustwärme aus dem Halbleiterchip zu gewährleisten. An die Homogenität der Lötverbindung werden hohe Anforderungen gestellt, vor allem bei gesteigerter Leistungsdichte, d.h. es werden definierte Dicke, gleichmässige Verteilung und einwandfreie Benetzung der Lotschicht über die ganze Chipfläche, bzw. völlige Blasenfreiheit sowie Reinheit der Lötstelle verlangt.

Der Erfindung liegt die Aufgabe zugrunde, einen Sensor zu entwickeln, mit dem überprüft werden kann, ob die Lotverteilung auf einem Substrat den geforderten Qualitätsansprüchen genügt.

Die genannte Aufgabe wird erfindungsgemäss gelöst durch die Merkmale des Anspruchs 1.

Zur Bestimmung der Art der Verteilung des Lotes auf dem Substrat bzw. der Form der Lotportion wird erfindungsgemäss ein induktiver Sensor eingesetzt. Die Erfindung macht dabei Gebrauch von der induktiven Abstandsmessung, bei der der ohmsche Widerstand und/oder die Induktivität einer mit einem Wechselstrom beaufschlagten Spule ändert, wenn ein metallischer Gegenstand oder eine metallische Flüssigkeit wie Lot in ihrem magnetischen Nahfeld bewegt wird. Bei der Erfindung wird die Lotportion unter dem induktiven Sensor hindurchtransportiert oder der Sensor wird über die Lotportion bewegt. Als induktiver Sensor dient vorzugsweise eine einzige Spule. Die Abmessung der Spule quer zur Transportrichtung ist grösser als die Breite der zu charakterisierenden Lotportion, so dass die Spule den über ihre Länge gemittelten Abstand zur Oberfläche der Lotportion misst.

Als induktiver Sensor kann aber auch ein Array von Spulen dienen, die alle kleiner als die Lotportion sind. Jede Spule tastet dann nur einen kleinen Bereich der Oberfläche der Lotportion ab.

Aus dem von der Spule gelieferten Signal bzw. den von den Spulen gelieferten Signalen wird dann ein binäres Signal abgeleitet, das angibt, ob die Lotportion mit einem Halbleiterchip zu bestücken ist, oder ob die Lotportion wegen ungenügender Qualität nicht zu bestücken ist.

Nachfolgend werden Ausführungsbeispiele der Erfindung anhand der Zeichnung näher erläutert.

Es zeigen:

Fig. 1    einen Montageautomaten zum Auflöten von Halbleiterchips auf ein Substrat,

Fig. 2    einen induktiven Sensor und Lotportionen,

Fig. 3    Signale des Sensors,

Fig. 4, 5    weitere induktive Sensoren, und

Fig. 6    einen in der LIGA Technologie hergestellten induktiven Sensor im Querschnitt.

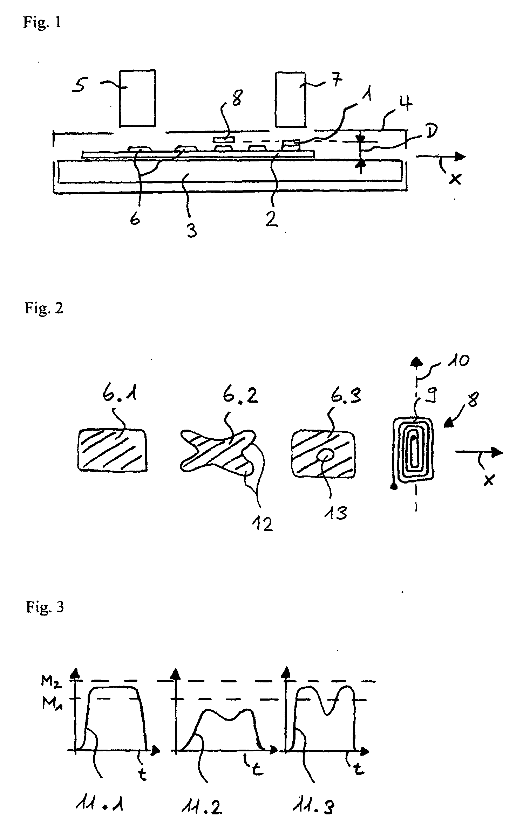

Die Fig. 1 zeigt im Querschnitt die für das Verständnis der Erfindung nötigen Teile eines Montageautomaten zum Auflöten von Halbleiterchips 1 auf ein Substrat 2. Der Montageautomat umfasst eine nicht dargestellte Transportvorrichtung, die das Substrat 2 in einer mit x bezeichneten Transportrichtung transportiert, wobei das Substrat 2 auf einer ebenen Platte 3 aufliegt. Die Transportvorrichtung befindet sich innerhalb eines Ofens 4, der das Substrat 2 auf eine vorbestimmte Temperatur aufheizt. Der Montageautomat umfasst weiter eine Lotstation 5, wo eine Lotportion 6 nach der anderen auf das Substrat 2 aufgebracht wird, und eine Bondstation 7, wo der Halbleiterchip 1 auf die Lotportion 6 abgesetzt wird. Lotstationen zum Aufbringen des Lots sind beispielsweise aus den Patenten EP 752294 und EP 852983 bekannt. Die ideale Lotportion 6 hat eine den Abmessungen des Halbleiterchips angepasste, rechteckige Form von gleichmässiger Dicke und ist blasenfrei. Zwischen der Lotstation 5 und der Bondstation 7 ist oberhalb der Platte 3 ein induktiver Sensor 8 angeordnet. Der Abstand D des induktiven Sensors 8 von der Platte 3 ist verstellbar. Der Abstand D wird in der Regel so eingestellt, dass zwischen der Lotportion 6 und dem induktiven Sensor 8 ein Abstand von ca. 0.5 mm bis 3 mm verbleibt.

Die Fig. 2 zeigt in der Aufsicht den induktiven Sensor 8, sowie drei Lotportionen 6.1 bis 6.3 mit unterschiedlicher Form. Der induktive Sensor 8 hat die Form einer länglichen Spule 9, deren Längsrichtung 10 quer zur Transportrichtung x verläuft. Die Länge L der Spule 9 ist grösser als die maximale Breite B der zu kontrollierenden Lotportion 6. Die Spule 9 liefert ein Signal, das vom mittleren Abstand zwischen der Lotportion 6 und der Spule 9 abhängt. Die drei Lotportionen 6.1 bis 6.3 erzeugen beim Passieren der Spule 9 wegen ihrer unterschiedlichen Form unterschiedliche Signale. Die Spule 9 wird mit einem hochfrequenten Wechselstrom beaufschlagt und erzeugt somit ein hochfrequentes Magnetfeld. Die Frequenz f des Wechselstroms ist so hoch gewählt, dass die Eindringtiefe des Magnetfeldes in die Lotportion 6 deutlich geringer ist als die Dicke der Lotportion 6. Die Eindringtiefe $\delta$ ist bestimmt durch den Skineffekt und lässt sich gemäss der Gleichung

$$\delta \approx \sqrt{\frac{1}{\pi\mu\sigma f}} \qquad (1)$$

berechnen, wobei $\mu$ die magnetische Permeabilität und $\sigma$ die elektrische Leitfähigkeit bezeichnen. Eine hohe Frequenz f drängt sich auch aus elektrotechnischen Gründen auf: Da die Induktivität L der Spule 9 in der Regel sehr gering ist und die Spule 9 mit einem Kondensator einen Schwingkreis bildet, ergibt sich nur dann ein vernünftiger Wert für die Kapazität C des Kondensators, wenn die Resonanzfrequenz des Schwingkreises sehr gross ist. Der Betrieb der Spule 9 und die Auswertung des von ihr gelieferten Signals erfolgt auf im Stand der Technik übliche Weise.

Die Fig. 3 zeigt den zeitlichen Verlauf der von der Spule 9 gelieferten Signale 11.1, 11.2 bzw. 11.3 für die drei Lotportionen 6.1 bis 6.3. Bevor die Lotportion 6.1 unter der Spule 9 passiert, liefert die Spule 9 ein relativ kleines Signal 11, das im wesentlichen vom Abstand der Spule 9 zum metallischen Substrat 2 abhängt. Beim Passieren der ersten Lotportion 6.1 steigt das Signal 11.1 an und sein Pegel entspricht dem über die Breite der Lotportion 6.1 gemittelten Abstand zwischen der Lotportion 6.1 und der Spule 9. Da die Lotportion 6.1 über die gesamte Länge gleichmässig breit und gleichmässig dick ist, ist der Pegel des Signals 11.1 annähernd konstant.

Bei der zweiten Lotportion 6.2 registriert die Spule 9 zunächst die beiden rechten Ausläufer 12 der Lotportion 6.2. Das Signal 11.2 steigt langsamer an als das Signal 11.1. Ob der Spitzenwert des Signals 11.2 grösser oder kleiner als der mittlere Wert des Signals 11.1 ist, kann nicht vorhergesagt werden, da das Signal der Spule 9 ein von der lokalen Dicke der Lotportion 6.2 abhängiges und über die Breite gemitteltes Integral darstellt. Das Signal 11.2 ist aber auf jeden Fall nicht konstant.

Bei der dritten Lotportion 6.3 erleidet das Signal 11.3 einen Einbruch, der auf die grosse Blase 13 im Lot zurückzuführen ist.

Bei der Auswertung des von der Spule 9 gelieferten Signals kann beispielsweise überprüft werden, ob das Signal 11 innerhalb eines vorgegebenen Fensters bleibt, d.h. einen vorgegebenen Mindestwert $M_1$ erreicht und einen vorgegebenen Maximalwert $M_2$ nicht unterschreitet. Bei den Signalen 11.2 und 11.3 ist diese Bedingung nicht erfüllt, während sie beim Signal 11.1 erfüllt ist. Auf diese Weise können mangelhafte Lotportionen detektiert und die Bondstation 7 (Fig. 1) angewiesen werden, eine als mangelhaft erkannte Lotportion nicht mit einem Halbleiterchip 1 zu bestücken.

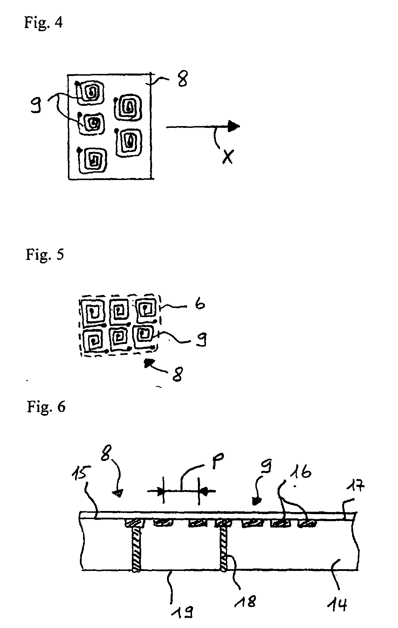

Die Fig. 4 zeigt eine andere Lösung zur Kontrolle der Form der Lotportionen 6. Der induktive Sensor 8 umfasst anstelle einer einzigen Spule 9 mehrere nebeneinander und hintereinander angeordnete Spulen 9. Die Spulen 9 sind vorzugsweise versetzt angeordnet, so dass die Oberfläche der Lotportion 6 beim Passieren lückenlos abgetastet werden kann. Die Spulen 9 werden bevorzugt abwechslungsweise im Zeitmultiplexbetrieb betrieben, um ein Übersprechen zu verhindern. Die von den Spulen 9 gelieferten Signale werden einer Auswerteeinheit zugeführt und ausgewertet.

Bei der Lotportion 6.1 erzeugen alle Spulen 9 ein gleiches Signal. Bei den Lotportionen 6.2 (Fig. 2) und 6.3 erzeugen die Spulen 9 hingegen andere Signale. Die Auswertung kann beispielsweise derart erfolgen, dass das Signal einer jeden Spule 9 mit einem Referenzsignal verglichen wird. Wenn das Signal von mindestens einer der Spulen 9 über ein gewisses Mass vom Referenzsignal abweicht, dann wird die Bondstation 7 (Fig. 1) angewiesen, die entsprechende Lotportion nicht mit einem Halbleiterchip 1 zu bestücken.

Bei allen Ausführungsbeispielen sind die Spulen 9 des induktiven Sensors 8 vorzugsweise Flachspulen. Bei dem anhand der Fig. 4 beschriebenen Ausführungsbeispiel sind die Spulen 9 in einer einzigen Ebene angeordnet. Alternativ können die Spulen 9 auch auf mindestens zwei elektrisch isolierte Ebenen verteilt sein, so dass die Spulen 9 teilweise überlappen können.

Bei den bisher beschriebenen Ausführungsbeispielen wurde der induktive Sensor 8 benutzt, um die Oberfläche der Lotportion 6 zu scannen. Die Relativverschiebung zwischen dem induktiven Sensor 8 und der Lotportion 6 erfolgt dabei durch eine Verschiebung der Lotportion 6, während der induktive Sensor 8 ortsfest angeordnet ist. Es ist aber auch möglich, den induktiven Sensor 8 zu bewegen, um die Oberfläche der Lotportion 6 abzutasten.

Der in der Fig. 5 dargestellte induktive Sensor 8 besteht aus mehreren nebeneinander angeordneten, auf zwei Leiterbahnebenen verteilten Spulen 9. Die von den Spulen 9 abgedeckte Fläche ist etwa so gross wie die Fläche der zu charakterisierenden Lotportion 6 und dieser angepasst. Dieser induktive Sensor 8 eignet sich zur Aufnahme einer Momentaufnahme. Dazu wird entweder der induktive Sensor 8 über die Lotportion 6 transportiert, und dann wird eine Spule 9 nach der andern mit Wechselstrom beaufschlagt und ihr Signal gespeichert. Oder es wird die Lotportion 6 unter dem induktiven Sensor 8 hindurchtransportiert und dann, wenn sich die Lotportion 6 unterhalb des induktiven Sensors 8 befindet, wird eine Spule 9 nach der andern mit Wechselstrom beaufschlagt und ihr Signal gespeichert. Der Vorschub der Lotportion 6 in Transportrichtung kann für die Momentaufnahme kurzzeitig unterbrochen werden. Falls allerdings der Vorschub während der Momentaufnahme klein ist gegenüber den Abmessungen der einzelnen Spulen 9 in Transportrichtung, dann muss der Vorschub nicht unterbrochen werden. Soweit sich verschiedene Spulen 9 gegenseitig nicht oder nur gering beeinflussen, können sie auch gleichzeitig abgefragt werden. Die Signale der Spulen 9 werden bevorzugt einem Mikroprozessor zugeführt, der die weitere Auswertung durchführt und ein binäres Signal liefert, ob die Lotportion 6 an der Bondstation mit einem Halbleiterchip zu bestücken ist oder nicht.

Die Fig. 6 zeigt den induktiven Sensor 8 im Querschnitt. Der induktive Sensor 8 umfasst ein Trägersubstrat 14, in dessen eine Oberfläche 15 eine spiralförmige Leiterbahn 16 eingebracht wurde, die die Windungen der Spule 9 bildet. Das Trägersubstrat 14 besteht vorzugsweise aus Glas oder einem anderen Isolationsmaterial. Die Oberfläche 15 des Trägersubstrats 14 ist fakultativ mit einer Schutzschicht 17 bedeckt. Die beiden Enden der Leiterbahn 16 sind über Durchkontaktierungen 18 von der Rückseite 19 des Trägersubstrates 14 elektrisch mit einer nicht gezeichneten Steuer- und Auswerteeinheit verbunden. Der induktive Sensor 8 kann beispielsweise mittels der LIGA Technik hergestellt werden. Dabei wird eine als Trägersubstrat 14 dienende Glasplatte mit Photoresist beschichtet, belichtet und entwickelt. Anschliessend wird an den belichteten Stellen, wo die Oberfläche 15 der Glasplatte freiliegt, in einem Ätzbad eine Vertiefung geätzt. Nach dem Ätzen wird eine Metallschicht aufgedampft und dann der Photoresist entfernt: Die Vertiefung enthält nun bereits die Leiterbahn 16, die zum Schluss aber noch galvanisch verstärkt wird. Anschliessend werden, fakultativ, die Schutzschicht 17 aufgebracht und die Leiterbahn 16 von der Rückseite 19 der Glasplatte her kontaktiert. Mit der LIGA Technologie lassen sich Flachspulen realisieren, bei denen der Pitch p von Windung zu Windung weniger als 10 $\mu$m beträgt.

Zudem ist ein derartiger induktiver Sensor 8 für den Betrieb bei hohen Temperaturen geeignet.

**Patentansprüche**

1.    Einrichtung für das Auflöten von Halbleiterchips (1) auf ein Substrat (2), mit einer Lotstation (5) zum Aufbringen einer Lotportion (6) auf das Substrat (2) und mit einer Bondstation (7) zum Plazieren eines Halbleiterchips (1) auf der Lotportion (6), **dadurch gekennzeichnet, dass** ein induktiver Sensor (8) vorhanden ist, der mindestens ein Signal (11.1; 11.2; 11.3) erzeugt, das von der Form der Lotportion (6) abhängig ist.

2.    Einrichtung nach Anspruch 1, bei der das Substrat (2) in einer Transportrichtung transportiert wird, **dadurch gekennzeichnet, dass** der induktive Sensor (8) mindestens eine längliche Spule (9) aufweist, deren Längsrichtung quer zur Transportrichtung verläuft.

3.    Einrichtung nach Anspruch 1, **dadurch gekennzeichnet, dass** der induktive Sensor (8) mehrere Spulen (9) umfasst.

4.    Einrichtung nach Anspruch 2 oder 3, **dadurch gekennzeichnet, dass** die Spulen (9) als Flachspulen ausgebildet sind.

5.    Einrichtung nach Anspruch 4, **dadurch gekennzeichnet, dass** der induktive Sensor (8) ein Trägersubstrat (14) umfasst und dass die Flachspulen durch Leiterbahnen (16) gebildet sind.

Fig. 1

Fig. 2

Fig. 3

Fig. 4

Fig. 5

Fig. 6

**Europäisches Patentamt**

**EUROPÄISCHER RECHERCHENBERICHT**

Nummer der Anmeldung

EP 01 81 0635

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | PATENT ABSTRACTS OF JAPAN vol. 007, no. 103 (E-173), 6. Mai 1983 (1983-05-06) -& JP 58 027327 A (TOKYO SHIBAURA DENKI KK), 18. Februar 1983 (1983-02-18) * Zusammenfassung * | 1-5 | H01L21/58 G01N27/02 |
| A | PATENT ABSTRACTS OF JAPAN vol. 2000, no. 16, 8. Mai 2001 (2001-05-08) -& JP 2001 012932 A (NAGOYA ELECTRIC WORKS CO LTD), 19. Januar 2001 (2001-01-19) * Zusammenfassung * | 1-5 | |
| A | DE 25 55 314 A (FISCHER GMBH & CO HELMUT) 23. Juni 1977 (1977-06-23) * das ganze Dokument * | 1-5 | |

| | | | RECHERCHIERTE SACHGEBIETE (Int.Cl.7) |
|---|---|---|---|
| | | | H01L G01N |

Der vorliegende Recherchenbericht wurde für alle Patentansprüche erstellt

| Recherchenort | Abschlußdatum der Recherche | Prüfer |
|---|---|---|
| MÜNCHEN | 27. November 2001 | Edmeades, M |

## ANHANG ZUM EUROPÄISCHEN RECHERCHENBERICHT
## ÜBER DIE EUROPÄISCHE PATENTANMELDUNG NR.

EP 01 81 0635

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

27-11-2001

| Im Recherchenbericht angeführtes Patentdokument | Datum der Veröffentlichung | Mitglied(er) der Patentfamilie | Datum der Veröffentlichung |
|---|---|---|---|
| JP 58027327 A | 18-02-1983 | KEINE | |
| JP 2001012932 A | 19-01-2001 | KEINE | |
| DE 2555314 A | 23-06-1977 | DE 2555314 A1 | 23-06-1977 |

Für nähere Einzelheiten zu diesem Anhang : siehe Amtsblatt des Europäischen Patentamts, Nr.12/82

EPO FORM P0461